# EUROPÄISCHE PATENTANMELDUNG

(11) **EP 1 624 571 A1**
(43) Veröffentlichungstag der Anmeldung: **08.02.2006**
(21) Anmeldenummer: 05016719.6
(22) Anmeldetag: 02.08.2005
(51) Int. Cl.: H03K 17/10

(54) **Schaltungsanordnung mit aktiven Bauelementen und hoher Durchbruchspannung**

(30) Priorität: 06.08.2004 DE 102004039619
(71) Anmelder: ATMEL Germany GmbH, 74072 Heilbronn (DE)
(72) Erfinder: Bromberger, Christoph, Dipl.-Phys., 74074 Heilbronn (DE); Dudek, Volker, Dr., 74336 Brackenheim (DE)

(57) **Zusammenfassung**

Vorgestellt wird eine Integrierte Schaltungsanordnung (10) mit einem ersten Schaltungsanschluss (12), einem zweiten Schaltungsanschluss (14) und aktiven Bauelementen (16, 18), wobei die aktiven Bauelemente (16, 18) jeweils einen Eingangsanschluss (20, 22) und einen Ausgangsanschluss (24, 26) und eine vorgegebene maximale Sperrspannung zwischen Eingangsanschluss (20, 22) und Ausgangsanschluss (24, 26) aufweisen, und wobei ein Maximalwert eines zwischen dem ersten Schaltungsanschluss (12) und dem zweiten Schaltungsanschluss (14) erzielten Spannungshubes größer als die vorgegebene maximale Sperrspannung ist. Die Schaltungsanordnung (10) zeichnet sich dadurch aus dass ein Eingangsanschluss (22) eines n-ten aktiven Bauelements (18) mit einem Ausgangsanschluss (24) eines (n-1)-ten aktiven Bauelements (16) verbunden ist, und dass die Schaltungsanordnung (10) die Potentiale an Steueranschlüssen des (n-1)-ten Bauelements (16) und des n-ten Bauelements (18) synchron zu einem Steuersignal (32) verändert.

## Beschreibung

Die Erfindung betrifft eine Integrierte Schaltungsanordnung mit einem ersten Schaltungsanschluss, einem zweiten Schaltungsanschluss und MOS-Transistoren, wobei die MOS-Transistoren jeweils einen Source-Anschluss und einen Drain-Anschluss und eine vorgegebene maximale Sperrspannung zwischen Source-Anschluss und Drain-Anschluss aufweisen, und wobei ein Maximalwert eines zwischen dem ersten Schaltungsanschluss und dem zweiten Schaltungsanschluss erzielten Spannungshubes größer als die vorgegebene maximale Sperrspannung ist, ein Source-Anschluss eines n-ten MOS-Transistors mit einem Drain-Anschluss eines (n-1)-ten MOS-Transistors verbunden ist, wobei die Schaltungsanordnung die Potentiale an Steueranschlüssen des (n-1)-ten MOS-Transistors und des n-ten MOS-Transistors synchron zu einem Steuersignal verändert.

Eine solche Integrierte Schaltungsanordnung ist aus der DE 197 55 134 C1 und aus der DE 199 26 109 A1 bekannt.

MOS-Transistoren stellen aktive Bauelemente dar, in denen sich veränderliche Raumladungen ausbilden. Beispiele solcher Bauelemente sind ferner insbesondere Halbleiterbauelemente wie Dioden und Transistoren.

Durch die Reihenschaltung von MOS-Elementen lassen sich gleichzeitig zwei Vorteile erzielen. Ein erster Vorteil liegt darin, dass sich mit einem einzigen Herstellungsverfahren, das auf eine bestimmte Sperrspannung hin optimiert ist, auch Marktsegmente bedienen lassen, die, zumindest in Teilen, höhere Sperrspannungen erfordern. Ein zweiter Vorteil ergibt sich daraus, dass der Einschaltwiderstand R_on eines MOS-Transistors im Allgemeinen quadratisch von seiner Sperrspannung abhängt. Für den Flächenbedarf zum Erreichen eines gegebenen R_on ist die Abhängigkeit von der Sperrspannung sogar noch ausgeprägter. Laterale MOS-Bauelemente werden, je nach gewünschter Sperrspannung, nach unterschiedlichen Bauprinzipien hergestellt: Für niedersperrende Logik-Bauelemente bauen sie ohne Driftzone oder Feldplatte und werden als MOS bezeichnet. Für den Mittelspannungsbereich um die 25 V verwendet man MOS ohne Feldplatte, aber mit Driftstrecke (MVMOS, MV = medium voltage), und im Spannungsbereich ab etwa 40 V kommen schließlich sogenannte HVMOS (HV = high voltage) mit Driftstrecke und Feldplatte zum Einsatz. Die drei Bauprinzipien zeigen unterschiedliche Konstanten R_on / Quadrat der Sperrspannung. Analoges gilt für den Flächenbedarf als Funktion der Sperrspannung. Zum Erzielen desselben R_on, wie sie ein gegebener HVMOS besitzt, braucht eine Reihenschaltung aus zum Beispiel drei MVMOS einerseits insgesamt eine 9-fache Gatelänge eines einzelnen MVMOS. Die Weite ist jedoch geringer als beim HVMOS, so dass sich bei großen Ausgangstreibern Fläche einsparen lässt.

Ferner sind Schaltungsanordnungen per se bekannt, die zwischen aktiven Bauelementen angeordnete passive Bauelemente mit einem Blindwiderstand aufweisen. Als Beispiel für eine solche bekannte Schaltungsanordnung wird auf die WO 02/23716 verwiesen. Diese Schrift zeigt einen Leistungsverstärker mit einer Reihenschaltung aus einem P-MOS-Transistor (P-MOS = P-Channel Metal Oxide Semiconductor), einer Induktivität und einem N-MOS-Transistor (N = N-Channel). Die beiden komplementären MOS-Transistoren werden durch zueinander inverse Eingangssignale jeweils gleichzeitig leitend oder sperrend gesteuert. Über ein LC-Netzwerk aus weiteren Induktivitäten und Kapazitäten ist eine Last mit einem Abgriff zwischen einem der beiden MOS-Transistoren und der Induktivität der Reihenschaltung verbunden. Durch diese Anordnung sollen Spannungsspitzen, denen die Transistoren als schaltende Elemente des Verstärkers ausgesetzt sind, auf Werte unterhalb von Durchbruchspannungen der Transistoren begrenzt werden. Als typische Anwendungsgebiete werden Hochfrequenzanwendungen genannt.

Es besteht bei vielen technischen Anwendungen das Problem, dass am Ausgang einer Schaltung statisch Spannungen gesteuert werden sollen, die Durchbruchspannungen üblicher Halbleiterbauelemente übersteigen. Für solche Schaltungen wurden bisher auch spezielle Halbleiterbauelemente verwendet, deren Durchbruchspannung durch weiter ausdiffundierte und niedriger dotierte Raumladungszonen erhöht wurde.

Bei Reihenschaltungen von MOS-Transistoren mit einer über der Reihenschaltung liegenden Spannung, die größer als die Durchbruchspannung eines einzelnen MOS-Transistors ist, besteht das Problem, das die Leitfähigkeit der MOS-Transistoren synchron gesteuert werden muss. Bei einer nicht synchron erfolgenden Steuerung, bei der ein erster MOS-Transistor eher in einen niederohmigen Zustand übergeht als ein zweiter MOS-Transistor, können Spannungsspitzen über dem zweiten MOS-Transistor auftreten, die seine Durchbruchspannung überschreiten.

Vor diesem Hintergrund besteht die Aufgabe der Erfindung in der Angabe von Schaltungsanordnungen, die ein Steuersignal synchron auf die verschiedenen Steueranschlüsse der MOS-Transistoren der Reihenschaltung verteilen, so dass Durchbruchspannungen der beteiligten MOS-Transistoren nicht überschritten werden.

Diese Aufgabe wird bei einer Schaltungsanordnung der eingangs genannten Art jeweils einzeln durch die kennzeichnenden Merkmale der nebengeordneten Ansprüche 1, oder 2, oder 3 gelöst.

Nach den kennzeichnenden Merkmalen des Anspruchs 1 weist die Schaltungsanordnung neben dem n-ten MOS-Transistor und dem (n-1)-ten MOS-Transistor wenigstens einen weiteren MOS-Transistor auf, dessen Source-Anschluss an einem ersten Versorgungspotentialanschluss liegt, dessen Drain-Anschluss über einen ersten Widerstand mit einem zweiten Versorgungspotential und über einen zweiten Widerstand mit einem Drain-Anschluss des n-ten MOS-Transistors verbunden ist, wobei ein Steueranschluss des n-ten MOS-Transistors mit einem Mittelabgriff eines Spannungsteilers verbunden ist, der zwischen dem Drain-Anschluss des (n-1)-ten MOS-Transistors und dem ersten Versorgungspotential der Schaltungsanordnung liegt.

Diese Lösung liefert einen mit dem Ausgang der Schaltung verbundenen Teilschaltkreis mit Leitungsanschlüssen und einem Steueranschluss, bei dem die Potentiale an den Leitungsanschlüssen und dem Steueranschluss durch weitere Teilschaltkreise synchron verschoben werden. Der mit dem Ausgang der Schaltung verbundene Teilschaltkreis überlagert dann dem Spannungshub, der an seinen Leitfähigkeitsanschlüssen auftritt, einen weiteren Spannungshub, so dass am Ausgang der Schaltung ein vergrößerter Spannungshub erzielt wird.

Die alternative Lösung des Anspruchs 2 umfasst die folgenden Merkmale: Die Schaltungsanordnung weist einen Lastkreis und eine Steuerschaltung auf; der Lastkreis weist eine Reihenschaltung einer ersten Anzahl r von MOS-Transistoren zwischen einem ersten Schaltungsanschluss und einem zweiten Schaltungsanschluss auf; die Steuerschaltung weist eine erste Reihenschaltung der Anzahl r von ersten MOS-Transistoren zwischen einem dritten Schaltungsanschluss und einem vierten Schaltungsanschluss sowie eine zweite Reihenschaltung der Anzahl r von zweiten MOS-Transistoren zwischen einem fünften Schaltungsanschluss und einem sechsten Schaltungsanschluss auf, welche ersten MOS-Transistoren komplementär zu den zweiten MOS-Transistoren und den MOS-Transistoren des Lastkreises sind; die Steuerschaltung weist ferner ein Widerstandsnetzwerk mit einer zweiten Anzahl s von Knotenpunkten auf, wobei die zweite Anzahl s um eines größer als die erste Anzahl r ist; der sechste Schaltungsanschluss liegt auf einem Referenzpotential; der erste Schaltungsanschluss ist mit dem dritten Schaltungsanschluss verbunden; der Steueranschluss des letzten der zweiten Transistoren bildet einen Steuereingang der Schaltungsanordnung; der Steueranschluss eines m-ten MOS-Transistors im Lastkreis ist mit dem Drain-Anschluss des m-ten der ersten MOS-Transistoren verbunden; der Steueranschluss des ersten MOS-Transistors der ersten MOS-Transistoren ist mit dem Mittelabgriff eines resistiven Spannungsteilers zwischen dem dritten und dem fünften Schaltungsanschluss verbunden; der vierte Schaltungsanschluss ist über einen Widerstand mit dem sechsten Schaltungsanschluss verbunden; ein erster Knotenpunkt des Widerstandsnetzwerkes ist mit dem dritten Schaltungsanschluss, ein s-ter Knotenpunkt des Widerstandsnetzwerkes ist mit dem sechsten Schaltungsanschluss verbunden; je ein n-ter Knotenpunkt des Widerstandsnetzwerkes ist mit einem (n+1)-ten Knotenpunkt des Widerstandsnetzwerkes über einen Widerstand verbunden; der Steueranschluss eines m-ten der ersten MOS-Transistoren, wobei die Anzahl m größer als die Anzahl eins und kleiner oder gleich der ersten Anzahl r ist, ist mit dem Mittelabgriff eines resistiven Spannungsteilers zwischen einem dem Steueranschluss des m-ten der ersten Transistoren vorangehenden Source-Drain-Gebiet und dem m-ten Knotenpunkt des Widerstandsnetzwerkes verbunden; und der Steueranschluss eines m-ten der zweiten MOS-Transistoren, wobei die Anzahl m größer oder gleich der Anzahl eins und kleiner als die erste Anzahl r ist, ist mit dem Mittelabgriff eines resistiven Spannungsteilers zwischen einem dem Steueranschluss des m-ten der zweiten Transistoren nachfolgenden Source-Drain-Gebiet und dem (m+1)-ten Knotenpunkt des Widerstandsnetzwerkes verbunden.

Dabei steht die Bezeichnung "Reihenschaltung einer Anzahl r von MOS-Transistoren" für eine Reihenschaltung von r MOS-Transistoren eines ersten Leitfähigkeitstyps, bei der je ein Drain-Anschluss eines MOS-Transistors mit einem ersten Schaltungsanschluss der Reihenschaltung oder genau einem Source-Anschluss eines weiteren der MOS-Transistoren sowie je ein Source-Anschluss eines der MOS-Transistoren mit einem zweiten Schaltungsamschluss der Reihenschaltung oder genau einem Drain-Anschluss eines weiteren der MOS-Transistoren verbunden ist. Ein "Source-Drain-Gebiet" bezeichnet dabei ein Source-oder ein Drain-Gebiet eines MOS-Transistors. Durch die Reihenschaltung einer Anzahl von N-MOS-Transistoren (P-MOS-Transistoren) wird eine Ordnung der Transistoren gegeben, dergestalt, dass der Drain-Anschluss (Source-Anschluss) des "ersten" Transistors an dem Schaltungsanschluss mit der niedrigeren Ordnungszahl liegt und der Drain-Anschluss (Source-Anschluss) eines "nächsten" Transistors mit dem Source-Anschluss (Drain-Anschluss) eines gegebenen MOS-Transistors verbunden ist. Bezogen auf einen Steueranschluss eines n-ten MOS-Transistors einer Reihenschaltung ist entsprechend unter dem "nachfolgenden (vorangehenden) Source-Drain-Gebiet" der Source-Anschluss (Drain-Anschluss) des n-ten MOS-Transistors zu verstehen.

Durch diese Lösung wird eine Steuersignaländerung an dem Steuereingang der Schaltungsanordnung parallel auf die Steueranschlüsse der Transistoren der übrigen Schaltungsanordnung verteilt. Als Konsequenz dieser Verteilung erfolgen Veränderungen der Leitfähigkeit dieser Transistoren koordiniert so, dass die Durchbruchspannungen der einzelnen Transistoren nicht überschritten werden. Diese Ausgestaltung mit resistiven Spannungsteilern sorgt auch im ausgeschalteten Zustand der Schaltungsanordnung für definierte Potentiale an den Steueranschlüssen, die sich als Folge eines Ruhestroms über die zwischen dem ersten Schaltungsanschluss und dem sechsten Schaltungsanschluss liegenden Widerstände einstellen.

Die alternative Lösung des Anspruchs 3 umfasst die folgenden Merkmale: Die Schaltungsanordnung weist einen Lastkreis und eine Steuerschaltung auf; der Lastkreis weist eine Reihenschaltung einer ersten Anzahl r von MOS-Transistoren zwischen einem ersten Schaltungsanschluss und einem zweiten Schaltungsanschluss auf; die Steuerschaltung weist eine erste Reihenschaltung der Anzahl r von ersten MOS-Transistoren zwischen einem dritten Schaltungsanschluss und einem vierten Schaltungsanschluss sowie eine zweite Reihenschaltung der Anzahl r von zweiten MOS-Transistoren zwischen einem fünften Schaltungsanschluss und einem sechsten Schaltungsanschluss auf, welche ersten MOS-Transistoren komplementär zu den zweiten MOS-Transistoren und den MOS-Transistoren des Lastkreises sind; der sechste Schaltungsanschluss liegt auf einem Referenzpotential; der erste Schaltungsanschluss ist mit dem dritten Schaltungsanschluss verbunden; der Steueranschluss des letzten der zweiten Transistoren bildet einen Steuereingang der Schaltungsanordnung; der Steueranschluss eines m-ten MOS-Transistors im Lastkreis ist mit dem Drain-Anschluss des m-ten der ersten MOS-Transistoren verbunden; der Steueranschluss des ersten der ersten MOS-Transistoren ist mit dem Mittelabgriff eines resistiven Spannungsteilers zwischen dem dritten und dem fünften Schaltungsanschluss verbunden; der vierte Schaltungsanschluss ist über einen Widerstand mit dem sechsten Schaltungsanschluss verbunden; der Steueranschluss eines m-ten der ersten MOS-Transistoren, wobei die Anzahl m größer als die Anzahl eins und kleiner oder gleich der ersten Anzahl r ist, ist mit dem Mittelabgriff eines kapazitiven Spannungsteilers aus Kapazitäten zwischen einem dem Steueranschluss des m-ten der ersten Transistoren vorangehenden Source-Drain-Gebiet und dem Steueranschluss des (m-1)-ten der zweiten Transistoren verbunden; und der Steueranschluss eines m-ten der zweiten MOS-Transistoren, wobei die Anzahl m größer oder gleich der Anzahl eins und kleiner als die erste Anzahl r ist, ist mit dem Mittelabgriff eines kapazitiven Spannungsteilers aus Kapazitäten zwischen einem dem Steueranschluss des m-ten der zweiten Transistoren nachfolgenden Source-Drain-Gebiet und dem Steueranschluss des (m+1)-ten der ersten Transistoren verbunden.

Auch diese Steuerschaltung verteilt eine Steuersignaländerung an dem Steuereingang der Schaltungsanordnung parallel auf die Steueranschlüsse der Transistoren der übrigen Schaltungsanordnung, so dass auch hier Veränderungen der Leitfähigkeit dieser Transistoren koordiniert so erfolgen, dass die Durchbruchspannungen der einzelnen Transistoren nicht überschritten werden. Ein zusätzlicher, aus der Verwendung von Kapazitäten zur Kopplung der Reihenschaltungen resultierender Vorteil besteht darin, dass eine stromlose Steuerung der Schaltungsanordnung möglich ist. Da kein Ruhestrom erforderlich ist, eignet sich diese Ausgestaltung insbesondere für Anwendungen, bei denen ein minimaler Stromverbrauch gefordert ist.

Eine Ausgestaltung sieht vor, dass ein Teil der Kapazitäten durch parasitäre Kapazitäten der MOS-Transistoren realisiert ist.

Diese Ausgestaltung ermöglicht eine Verringerung der Zahl separater Kapazitäten und damit eine Verringerung des Platzbedarfes der Schaltung.

Im Rahmen weiterer Ausgestaltungen ist bevorzugt, dass pn-Übergänge verschiedener Bauelemente in verschiedenen, durch Isolationsstrukturen voneinander getrennten Bereichen eines Halbleitersubstrates auf verschiedenen Potentialen liegen.

Durch diese Ausgestaltung wird gewissermaßen ein einzelner pn-Übergang durch mehrere, hintereinander liegende pn-Übergänge ersetzt, die durch Isolationsstrukturen getrennt sind und die auf unterschiedlichen Potentialen liegen. Durch diese Ausgestaltung ergibt sich eine immense Erweiterung der Anwendungen von integrierten Schaltungen als Folge der möglichen Vervielfachung des Ausgangsspannungs-Steuerbereichs.

Weitere Vorteile ergeben sich aus der Beschreibung und den beigefügten Figuren. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert. Es zeigen, jeweils schematisch:
- Fig. 1: eine Reihenschaltung von MOS-Transistoren;
- Fig. 2: einen Querschnitt durch eine Reihenschaltung aus der Fig. 1 bei einer Realisierung als integrierte Schaltung;
- Fig. 3: ein erstes Ausführungsbeispiel der Erfindung;
- Fig. 4: ein weiteres Ausführungsbeispiel der Erfindung; und
- Fig. 5: ein weiteres Ausführungsbeispiel der Erfindung.

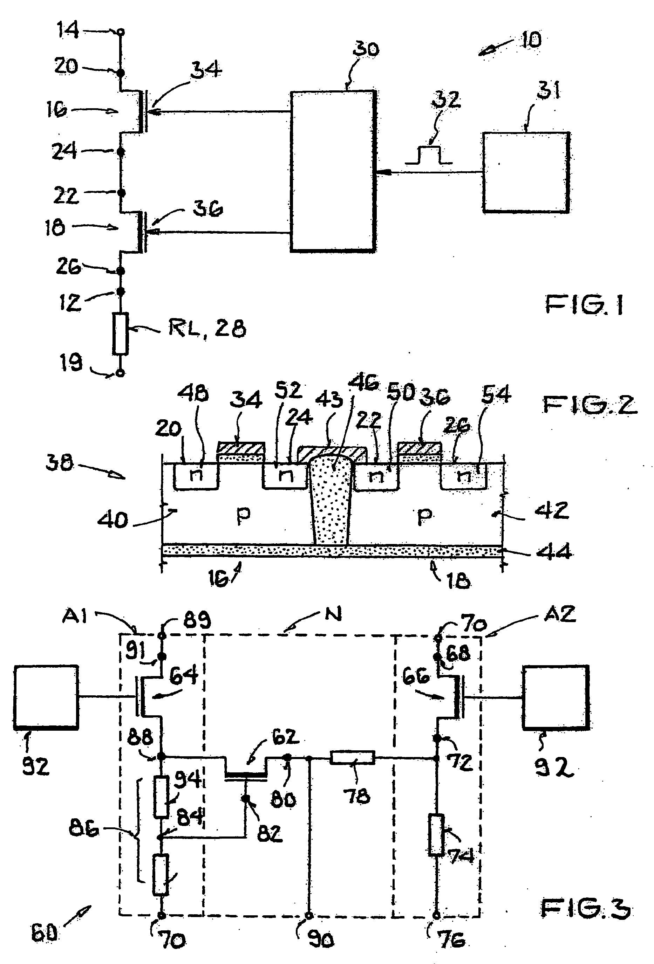

Fig. 1 zeigt eine Schaltungsanordnung 10 mit einem ersten Schaltungsanschluss 12, einem zweiten Schaltungsanschluss 14 und aktiven Bauelementen 16, 18, wobei die aktiven Bauelemente 16, 18 jeweils einen Eingangsanschluss 20, 22, einen Ausgangsanschluss 24, 26 und eine vorgegebene maximale Sperrspannung zwischen Eingangsanschluss 20, 22 und Ausgangsanschluss 24, 26 aufweisen. Die aktiven Bauelemente 16, 18 können zum Beispiel selbstsperrende (normally off, enhancement type) HVN-MOS-Transistoren mit einer maximalen Sperrspannung von 65 Volt sein. Sie sind in Reihe geschaltet, so dass ein Eingangsanschluss 22 eines n-ten aktiven Bauelements 18 mit einem Ausgangsanschluss 24 eines (n-1)-ten aktiven Bauelements 16 verbunden ist. Zwischen dem ersten Schaltungsanschluss 12 und einem Bezugspotentialanschluss 19 liegt eine Last 28, die in der Fig. 1 stellvertretend für sämtliche Ausführungen elektrischer Lasten als Lastwiderstand RL dargestellt ist.

Durch die Reihenschaltung der aktiven Bauelemente 16, 18 fällt über jedem der aktiven Bauelemente 16, 18 nur ein Teil der gesamten zwischen den Schaltungsanschlüssen 12, 14 liegenden Spannung ab. Der Maximalwert einer zwischen dem ersten Schaltungsanschluss 12 und dem zweiten Schaltungsanschluss 14 zulässigen Spannung ist daher größer als eine vorgegebene maximale Sperrspannung eines einzelnen aktiven Bauelements 16 oder 18. Entsprechend kann eine zur Schaltungsanordnung 10 zugehörige Steuerschaltung 30, die von einem Steuersignalgeber 31 gesteuert wird, durch synchron zu einem Steuersignal 32 erfolgende Veränderungen von Potentialen an Steueranschlüssen 34, 36 der aktiven Bauelemente 16, 18 einen Spannungshub zwischen dem ersten Schaltungsanschluss 12 und dem zweiten Schaltungsanschluss 14 der Schaltungsanordnung 10 einstellen, der den Wert der maximalen Sperrspannung eines einzelnen aktiven Bauelements 16 oder 18 übersteigt.

Dabei können die an Steueranschlüsse 34, 36 übergebenen Signale gleichgerichtet sein. Sie können aber auch invers zueinander sein, um komplementäre (N-MOS, P-MOS) Transistoren in einer Reihenschaltung synchron zu steuern.

Im Beispiel der Fig. 1 kann das Potential am zweiten Schaltungsanschluss 14 zum Beispiel um 100 Volt positiver sein als das Bezugspotential am Bezugspotentialanschluss 19. Bei einer solchen "low-side" Anordnung der Last 28 stellt sich bei nichtleitend gesteuerten aktiven Bauelementen 16, 18, also wenn kein Strom über die Schaltungsanordnung 10 fließt, am ersten Schaltungsanschluss 12 das Potential des Bezugspotentialanschlusses 19 ein, so dass über der Reihenschaltung der aktiven Bauelemente 16, 18 eins Spannung von 100 Volt abfällt. Bei untereinander gleichen aktiven Bauelementen 16, 18 fällt dann über jedem einzelnen der aktiven Bauelemente 16, 18 eine Spannung von 50 Volt ab, so dass die zulässige Sperrspannung von 65 Volt nicht überschritten wird.

Im Vergleich mit einem Einzeltransistor wird damit bei einem Aufbau der Schaltungsanordnung 10 aus Halbleiterbauelementen ein einzelner bedarfsweise gesperrter pn-Übergang durch mehrere, in Reihe geschaltete pn-Übergänge ersetzt. Dabei müssen die Bereiche des Halbleitersubstrats, in denen die in Reihe geschalteten pn-Übergänge liegen, gegeneinander isoliert sein. Dabei werden Bereiche als gegeneinander isoliert verstanden, wenn sie auf wesentlich verschiedenen Potentialen liegen, ohne dass zwischen ihnen ein nutzbarer Strom fließt. Bei einer Realisierung der Reihenschaltung aus diskreten aktiven Bauelementen 16, 18 ist eine solche Isolierung von vornherein gegeben. Bei einer Realisierung in Form einer integrierten Schaltung müssen die entsprechenden Bereiche des Halbleitersubstrates dagegen gegeneinander isoliert werden. Diese Isolation kann beispielsweise durch geeignet hochsperrende pn-Übergänge oder auch auf dielektrische Weise erfolgen.

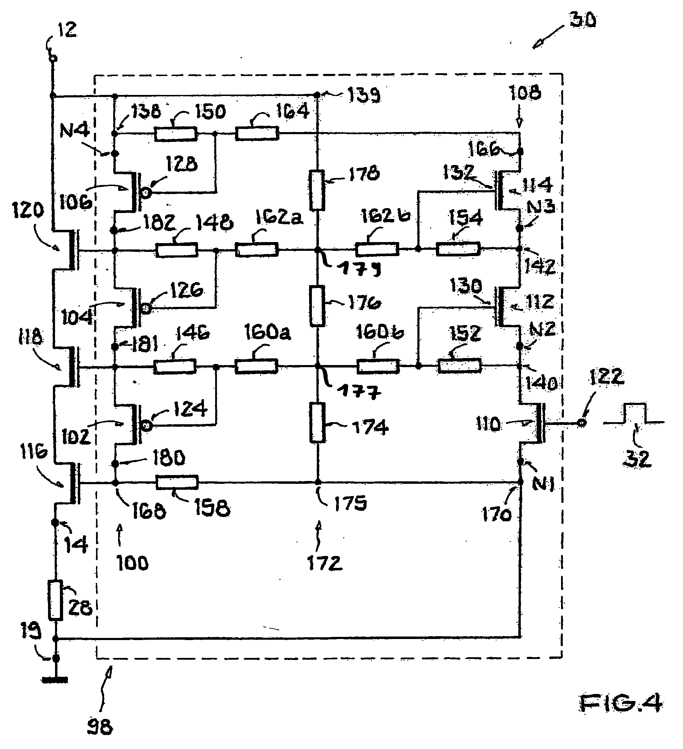

Fig. 2 zeigt einen Ausschnitt 38 aus einer integrierten Schaltung mit einer Reihenschaltung von aktiven Bauelementen 16 und 18 in Form von N-MOS-Transistoren. Verschiedene Bereiche 40, 42 eines p-leitenden Substrats, das sich auf einer Isolierschicht 44 erstreckt (SOI-Struktur, SOI = semiconductor on insulator), sind durch eine isolierende, mit einem Dielektrikum gefüllte Grabenstruktur 46 gegeneinander isoliert. n-dotierte Bereiche 48, 50 bilden Drain-Gebiete, während n-dotierte Bereiche 52, 54 als Source-Gebiete dienen. Die Grenzen zwischen den n-dotierten Bereichen 48, 50, 52, 54 und den p-dotierten Bereichen 40, 42 stellen im nichtleitenden Zustand pn-Übergänge dar.

Mit den oben angegebenen Beispielwerten liegen die pn-Übergänge im sperrenden Zustand im linken Teil des Ausschnitts 38 der Schaltung zwischen 100 Volt am Eingangsanschluss 20 und 50 Volt am Ausgangsanschluss 24, während sie im rechten Teil zwischen 50 Volt am Eingangsanschluss 22 und 0 Volt am Ausgangsanschluss 26 liegen. Die Anschlüsse 20, 22, 24, 26, 34, 36 sind bereits im Zusammenhang mit der Fig. 1 erläutert worden. Über eine leitende Verbindung 43 der Anschlüsse 22 und 24 werden beide aktiven Bauelemente (N-MOS-Transistoren) 16, 18 in Reihe geschaltet. Über eine Ansteuerung der Steueranschlüsse 34, 36 mit einem gegenüber den Source-Gebieten 52, 54 positiven Potential werden n-leitende Kanäle zwischen den n-dotierten Bereichen 48 (Drain) und 52 (Source) sowie 50 (Drain) und 54 (Source) erzeugt, um die Reihenschaltung leitend zu steuern. In Verbindung mit Fig. 1 zeigt Fig. 2 damit eine als integrierte Schaltung realisierte Schaltungsanordnung, in der pn-Übergänge verschiedener aktiver Bauelemente 16, 18 in verschiedenen, durch Isolationsstrukturen 46 voneinander getrennten Bereichen 40, 42 eines p-leitenden Halbleitersubstrates auf verschiedenen Potentialen liegen. Ferner zeigt Fig. 1 in Verbindung mit Fig. 2 eine Schaltungsanordnung 10 mit MOS-Transistoren als aktive Bauelemente 16, 18, wobei Eingangsanschlüsse 20, 22 der aktiven Bauelemente 16, 18 durch Drainanschlüsse der MOS-Transistoren und Ausgangsanschlüsse 24 der aktiven Bauelemente durch Source-Anschlüsse der MOS-Transistoren gebildet werden.

Fig. 3 zeigt eine Ausgestaltung einer Schaltungsanordnung 60, die neben einem n-ten MOS-Transistor 62 und einem (n-1)-ten MOS-Transistor 64 einen weiteren MOS-Transistor 66 aufweist, dessen Source-Anschluss 68 an einem ersten Versorgungspotential von z.B. 50 Volt an einem Anschluss 70 liegt, dessen Drain-Anschluss 72 über einen ersten Widerstand 74 mit einem zweiten Versorgungspotential von zum Beispiel 100 Volt an einem Anschluss 76 und über einen zweiten Widerstand 78 mit einem Drain-Anschluss 80 des n-ten MOS-Transistors 62 verbunden ist, wobei ein Steueranschluss 82 des n-ten MOS-Transistors 62 mit einem Mittelabgriff 84 eines Spannungsteilers 86 verbunden ist, der zwischen einem Source-Drain-Gebiet 88 als Drain-Anschluss des (n-1)-ten MOS-Transistors 64 und dem ersten Versorgungspotential (Anschluss 70) der Schaltungsanordnung 60 liegt. Ein Widerstand 94 liegt hierbei als Teilwiderstand des Spannungsteilers 86 zwischen dem Source-Drain-Gebiet 88 und dem Mittelabgriff 84 des Spannungsteilers 86. Ein Source-Anschluss 91 des (n-1)-ten MOS-Transistors 64 ist mit einem Anschluss 89 der Schaltung 60 verbunden. Am Anschluss 89 liegt ein Bezugspotential von zum Beispiel 0 Volt an.

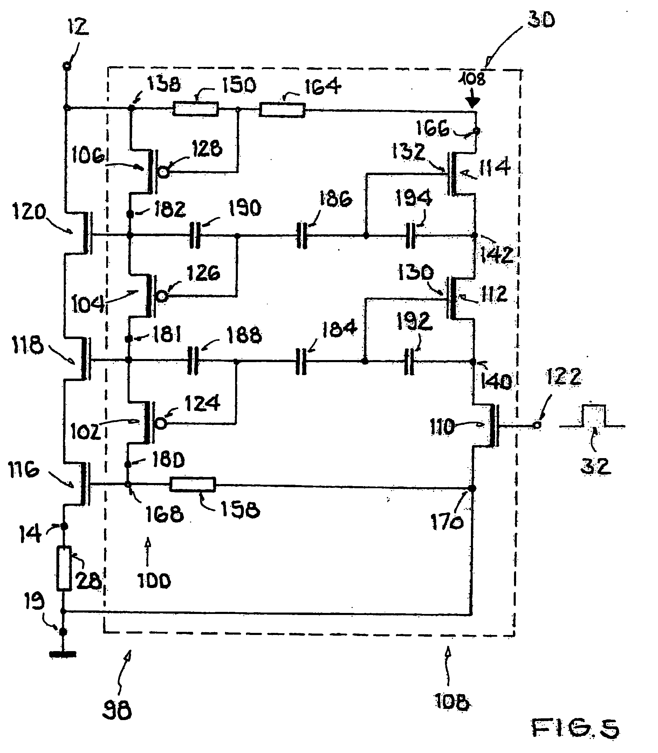

Mit Hilfe der Schaltungsanordnung 60 wird am Anschluss 90 eine Ausgangsspannung eingestellt, wobei die Einstellung mit Hilfe einer Steuerschaltung 92 erfolgt. Der (n-1)-te MOS-Transistor 64 und der weitere MOS-Transistor 66 werden von der Steuerschaltung 92 synchron gesteuert, wobei für die weitere Erläuterung vereinfachend eine digitale EIN/AUS-Steuerung angenommen wird. Es versteht sich aber, dass zwischen den resultierenden Minimal- und Maximalwerten, die den Spannungshub am Anschluss 90 definieren, auch sämtliche zwischen den Extremwerten liegenden Werte eingestellt werden können. Dies gilt in übrigen auch für die weiter unten beschriebenen Ausgestaltungen nach den Figuren 4 und 5.

Mit den angegebenen Beispielwerten ergibt sich, wenn der (n-1)-te MOS-Transistor 64 und der weitere MOS-Transistor 66 sperren, an dem Source-Drain-Gebiet 88 und dem Mittelabgriff 84 das gleiche Potential von 50 Volt, so dass der (selbstsperrende) n-te MOS-Transistor 62 aufgrund der fehlenden Potentialdifferenz zwischen Steueranschluss 82 und Source-Drain-Gebiet 88 sperrt. Als Folge greift das Potential vom Anschluss 76 auf den Anschluss 90 durch, so dass sich dort 100 Volt einstellen. In diesem Zustand muss die Reihenschaltung aus n-tem MOS-Transistor 62 und (n-1)-tem MOS-Transistor 64 entsprechend eine Spannung von 100 Volt zum Anschluss 89 sperren.

Werden die MOS-Transistoren 64 und 66 dagegen synchron von der Steuerschaltung 92 eingeschaltet, so fließen Ströme über den Spannungsteiler 86 und über den ersten Widerstand 74. Die Spannungen am Source-Drain-Gebiet 88 und dem Mittelabgriff 84 sinken ab, wobei der zwischen ihnen liegende Widerstand 94 die Spannung am Source-Drain-Gebiet 88 stärker reduziert. Als Folge ergibt sich eine positive Spannung zwischen dem Steueranschluss 82 und dem Source-Drain-Gebiet 88, so dass der n-te MOS-Transistor 62 leitet. Durch den Strom über den ersten Widerstand 74 sinkt das Potential am verbleibenden Drain-Anschluss 80 des n-ten MOS-Transistors 62 ebenfalls ab, so dass die Teilschaltungen A1 und A2 die Potentiale an dem Drain-Anschluss 72, dem Source-Drain-Gebiet 88 und dem Steueranschluss 82 synchron verschieben. Drain-Anschluss 72, Source-Drain-Gebiet 88 und Steueranschluss 82 bilden Anschlüsse einer Teilschaltung N an Teilschaltungen A1 und A2. Die Teilschaltungen A1 und A2 verschieben damit Potentiale an Anschlüssen der Teilschaltung N und damit an Anschlüssen des n-ten MOS-Transistors 62 synchron zueinander. Bei entsprechender Dimensionierung der Widerstände ergibt sich dann bei leitenden Transistoren 64 und 66 ein Potential von 10 Volt am Anschluss 90 und damit ein schaltbarer oder steuerbarer Spannungshub von 90 Volt. Die Schaltung 60 bewirkt damit, dass den Änderungen der Spannungen an dem Source-Drain-Gebiet 88 und dem Drain-Anschluss 80 des n-ten Transistors 62, die in der Größenordnung von ca. 50 Volt liegen, noch der Spannungshub des Transistors 64 überlagert wird. Dabei werden die Potentiale am Source-Drain-Gebiet 88, am Steueranschluss 82 und am Drain-Anschluss 80 synchron so verschoben, dass die maximale Sperrspannung von zum Beispiel 65 Volt nicht überschritten wird.

Fig. 4 zeigt eine Schaltungsanordnung 98 mit einem Lastkreis und einer Steuerschaltung 30. Der Lastkreis weist eine Reihenschaltung einer ersten Anzahl r = 3 von MOS-Transistoren 120, 118, 116 zwischen einem ersten Schaltungsanschluss 12 und einem zweiten Schaltungsanschluss 14 sowie eine Last 28 auf. Die Steuerschaltung 30 weist eine erste Reihenschaltung 100 der Anzahl r von ersten MOS-Transistoren 106, 104, 102 zwischen einem dritten Schaltungsanschluss 138 und einem vierten Schaltungsanschluss 168 sowie eine zweite Reihenschaltung 108 der Anzahl r von zweiten MOS-Transistoren 114, 112, 110 zwischen einem fünften Schaltungsanschluss 166 und einem sechsten Schaltungsanschluss 170 auf. Dabei sind die ersten MOS-Transistoren 106, 104, 102 komplementär zu den zweiten MOS-Transistoren 114, 112, 110 und den MOS-Transistoren 120, 118, 116 des Lastkreises. Bei P-MOS-Transistoren (N-MOS-Transistoren) als erste Transistoren sind die zweiten Transistoren und die Transistoren des Lastkreises also N-MOS-Transistoren (P-MOS-Transistoren). Die Steuerschaltung 30 weist ferner ein Widerstandsnetzwerk mit einer zweiten Anzahl s von Knotenpunkten 139, 179, 177, 175 auf, wobei die zweite Anzahl s um eines größer als die erste Anzahl r ist. Der sechste Schaltungsanschluss 170 liegt auf einem Referenzpotential. Der erste Schaltungsanschluss 12 ist mit dem dritten Schaltungsanschluss 138 verbunden. Ein Steueranschluss 122 des letzten 110 der zweiten Transistoren 114, 112, 110 bildet einen Steuereingang der Schaltungsanordnung 98.

Ein Steueranschluss eines m-ten der MOS-Transistoren 120, 118, 116 im Lastkreis ist mit einem Source-Drain-Gebiet 180, 181, 182 (Drain-Anschluss) des m-ten der ersten MOS-Transistoren 106, 104, 102 verbunden. Ein Steueranschluss 128 des ersten MOS-Transistors 106 der ersten MOS-Transistoren 106, 104, 102 ist mit dem Mittelabgriff eines resistiven Spannungsteilers zwischen dem dritten 138 und dem fünften Schaltungsanschluss 166 verbunden. Der resistive Spannungsteiler besteht dabei aus Widerständen 150, 164. Der vierte Schaltungsanschluss 168 ist über einen Widerstand 158 mit dem sechsten Schaltungsanschluss 170 verbunden. Der erste Knotenpunkt 139 des Widerstandsnetzwerkes ist mit dem dritten Schaltungsanschluss 138 und der s-te Knotenpunkt 175 des Widerstandsnetzwerkes ist mit dem sechsten Schaltungsanschluss 170 verbunden. Der n-te Knotenpunkt 139, 179, 177 des Widerstandsnetzwerkes ist jeweils mit dem (n+1)-ten Knotenpunkt 179, 177, 175 des Widerstandsnetzwerkes über einen Widerstand 178, 176, 174 verbunden. Ein Steueranschluss 126, 124 eines m-ten der ersten MOS-Transistoren 104, 102, wobei die Anzahl m größer als die Anzahl eins und kleiner oder gleich der ersten Anzahl r ist, ist mit dem Mittelabgriff eines resistiven Spannungsteilers aus Widerständen 148,162a bzw. 146, 160a zwischen einem dem Steueranschluss des m-ten der ersten MOS-Transistoren 104, 102 vorangehenden Source-Drain-Gebiet 182, 181 und dem m-ten Knotenpunkt 179, 177 des Widerstandsnetzwerkes verbunden. Das Source-Drain-Gebiet 182, 181 bildet einen Source-Anschluss des MOS-Transistors 104, 102. Ein Steueranschluss 132, 130 eines m-ten der zweiten MOS-Transistoren 114, 112, wobei die Anzahl m größer oder gleich der Anzahl eins und kleiner als die erste Anzahl r ist, ist mit einem Mittelabgriff eines resistiven Spannungsteilers aus Widerständen 162b, 154, bzw. 160b, 152 zwischen einem dem Steueranschluss 132, 130 des m-ten der zweiten Transistoren 114, 112 nachfolgenden Source-Drain-Gebiet 142, 140 und dem (m+1)-ten Knotenpunkt 179, 177 des Widerstandsnetzwerkes verbunden. Das Source-Drain-Gebiet 142, 140 bildet einen Drain-Anschluss des MOS-Transistors 112, 110 und ist mit als Sourceanschlüssen der MOS-Transistoren 114, 112 dienenden Source-Drain-Gebieten N3, N2 verbunden.

Durch einen Spannungsteiler 172 aus den Ohm'schen Widerständen 174, 176, 178 werden Verbindungen von Souce-Drain-Gebieten 180, 181, 182 der ersten MOS-Transistoren 102, 104, 106, die dort als Drainanschlüsse dienen, mit Source-Drain-Gebieten N1, N2, N3 der zweiten MOS-Transistoren 110, 112, 114, die dort als Source-Anschlüsse dienen, in einem ersten Betriebszustand der Schaltung 98, in dem die MOS-Transistoren 102, 104, 106, 110, 112, 114, 116, 118, 120 gesperrt sind, auf definierte Potentiale gelegt. Im ersten Betriebszustand fällt insbesondere über jedem der MOS-Transistoren 102, 104, 106 und 116, 118, 120 etwa ein Drittel der Spannung zwischen den Schaltungsanschlüssen 12 und 14 ab, die zum Beispiel 150 Volt betragen kann.

Ein positives Eingangssignal 32 steuert den MOS-Transistor 110 leitend. Dadurch entsteht neben einem Ruhestrompfad über den Spannungsteiler 172 ein weiterer Strompfad über die Widerstände 160b, 152 und den MOS-Transistor 110. Als Folge sinkt das Potential am Source-Drain-Gebiet N2 des MOS-Transistors 112. Der Stromfluss über den Widerstand 152 erzeugt eine Potentialdifferenz zwischen Source-Drain-Gebiet N2 und Steueranschluss 130 des MOS-Transistors 112, die diesen ebenfalls leitend steuert. Analog wird der MOS-Transistor 114 leitend gesteuert. Der Stromfluss über den MOS-Transistor 114 erzeugt einen Spannungsabfall von einem als Source-Anschluss des MOS-Transistors 106 dienenden Source-Drain-Gebiet N4 zum Steueranschluss 128 dieses MOS-Transistors, die den MOS-Transistor 106 in den leitenden Zustand steuert. Analog werden die MOS-Transistoren 104 und 102 in den leitenden Zustand gesteuert.

Als Folge der leitenden MOS-Transistoren 102, 104, 106 greift das hohe Potential vom Schaltungsanschluss 14 auf die Steueranschlüsse der MOS-Transistoren 116, 118 120 durch, so dass diese ebenfalls leiten. Dadurch ergibt sich mit dem angegebenen Beispielwert von 150 Volt am Schaltungsanschluss 12 ein Spannungshub von 0 zu etwa 150 Volt, wobei jeder der Transistoren 116, 118, 120 nur etwa 50 Volt sperren muss.

Bei einer konkreten Ausgestaltung haben sich an einzelnen Punkten der Schaltung im eingeschalteten Zustand und im ausgeschalteten Zustand folgende Spannungen in Volt ergeben:

| Anschluss | Zustand: aus | Zustand: ein |
|---|---|---|
| 12, 138, 139 | 150 | 150 |
| 179 | 100 | 100 |
| 177 | 50 | 50 |
| 19, 170, 175 | 0 | 0 |
| 122 | 0 | 5 |
| 140 | 50 | 1 |
| 130 | 50 | 6 |
| 142 | 100 | 2 |
| 132 | 100 | 7 |
| 166 | 150 | 3 |
| 128 | 150 | 144 |
| 136 | 100 | 149 |
| 126 | 100 | 143 |
| 134 | 50 | 148 |
| 124 | 50 | 142 |
| 168 | 0 | 147 |
| 14 | 0 | 146 |

Bei dieser konkreten Ausgestaltung mit der Last 28 am Bezugspotentialanschluss 19 (low side) muss also für einen Spannungshub von 150 Volt am zweiten Schaltungsanschluss 14 am Steueranschluss 124 des Transistors 102 im Lastkreis eine Spannung von 150 Volt ohne Last geschaltet werden können. Dies wird durch die Steuerschaltung 30 ermöglicht.

Fig. 5 zeigt ebenfalls eine Schaltungsanordnung 98 mit einem Lastkreis und einer Steuerschaltung 30. Der Lastkreis weist eine Reihenschaltung von r = 3 MOS-Transistoren 120, 118, 116 zwischen einem ersten Schaltungsanschluss 12 und einem zweiten Schaltungsanschluss 14 sowie eine Last 28 zwischen dem zweiten Schaltungsanschluss 14 und einem Bezugspotentialanschluss 19 auf. Die Steuerschaltung 30 weist eine erste Reihenschaltung 100 der Anzahl r von ersten MOS-Transistoren 106, 104, 102 zwischen einem dritten Schaltungsanschluss 138 und einem vierten Schaltungsanschluss 168 sowie eine zweite Reihenschaltung 108 der Anzahl r von zweiten MOS-Transistoren 114, 112, 110 zwischen einem fünften Schaltungsanschluss 166 und einem sechsten Schaltungsanschluss 170 auf. Die ersten MOS-Transistoren 106, 104, 102 sind auch hier komplementär zu den zweiten MOS-Transistoren 114, 112, 110 und den MOS-Transistoren 120, 118, 116 des Lastkreises. Der sechste Schaltungsanschluss 170 liegt auf einem Referenzpotential und der erste Schaltungsanschluss 12 ist mit dem dritten Schaltungsanschluss 138 verbunden. Der Steueranschluss 122 des letzten 110 der zweiten Transistoren 114, 112, 110 bildet einen Steuereingang der Schaltungsanordnung 98. Im übrigen bezeichnen gleiche Bezugszeichen in den Figuren 4 und 5 jeweils gleiche Gegenstände.

Der Steueranschluss eines m-ten der MOS-Transistoren 120, 118, 116 im Lastkreis ist mit einem Source-Drain-Gebiet 182, 181, 180 (Drain-Anschluss) des m-ten der ersten MOS-Transistoren 106, 104, 102 verbunden. Ein Steueranschluss 128 des ersten 106 der ersten MOS-Transistoren 106, 104, 102 ist mit dem Mittelabgriff eines resistiven Spannungsteilers aus Widerständen150, 164 zwischen dem dritten 138 und dem fünften Schaltungsanschluss 166 verbunden. Der vierte Schaltungsanschluss 168 ist über einen Widerstand 158 mit dem sechsten Schaltungsanschluss 170 verbunden. Der Steueranschluss 126, 124 eines m-ten der ersten MOS-Transistoren 104, 102, wobei die Anzahl m größer als die Anzahl eins und kleiner oder gleich der ersten Anzahl r ist, ist mit dem Mittelabgriff eines kapazitiven Spannungsteilers aus Kapazitäten 190, 186; 188, 184 zwischen einem dem Steueranschluss 126, 124 des m-ten der ersten Transistoren 104, 102 vorangehenden Source-Drain-Gebiet 182, 181 und dem Steueranschluss 132, 130 des (m-1)-ten der zweiten Transistoren 114, 112 verbunden. Das Source-Drain-Gebiet 182, 181 bildet einen Source-Anschluss des MOS-Transistors 104, 102.

Ein Steueranschluss 132, 130 eines m-ten der zweiten MOS-Transistoren 114, 112, wobei die Anzahl m größer oder gleich der Anzahl eins und kleiner als die erste Anzahl r ist, ist mit dem Mittelabgriff eines kapazitiven Spannungsteilers aus Kapazitäten 186, 194; 184, 192 zwischen einem dem Steueranschluss 132, 130 des m-ten der zweiten Transistoren 114, 112 nachfolgenden Source-Drain-Gebiet 142, 140 und dem Steueranschluss 126, 124 des (m+1)-ten der ersten Transistoren 104, 102 verbunden. Das Source-Drain-Gebiet 142, 140 bildet einen Drain-Anschluss des MOS-Transistors 112, 110 und ist mit als Sourceanschlüssen der MOS-Transistoren 114, 112 dienenden Source-Drain-Gebieten N3, N2 verbunden.

Da der resistive Spannungsteiler 172 aus Fig. 4 einen Strompfad für einen Ruhestrom bereitstellt, verbraucht der Gegenstand der Fig. 4 auch im Ruhezustand einen gewissen Strom. Für Anwendungen, bei denen ein solcher Stromverbrauch unerwünscht ist, zum Beispiel bei mobilen Anwendungen, ist an Stelle der Ausgestaltung nach Fig. 4 die Ausgestaltung nach Fig. 5 besser geeignet. Der Gegenstand der Fig. 5 stellt eine Ausgestaltung dar, die ohne den resistiven Spannungsteiler auskommt und an dessen Stelle kapazitive Spannungsteiler verwendet.

Dabei können die Kapazitäten 188, 190, 192, 194 durch parasitäre Kapazitäten der MOS-Transistoren realisiert sein.

## Patentansprüche

1. Integrierte Schaltungsanordnung (60) mit einem ersten Schaltungsanschluss (89), einem zweiten Schaltungsanschluss (90) und MOS-Transistoren (62, 64), wobei die MOS-Transistoren (62, 64) jeweils einen Source-Anschluss (88, 91) und einen Drain-Anschluss (80, 88) und eine vorgegebene maximale Sperrspannung zwischen Source-Anschluss (88, 91) und Drain-Anschluss (80, 88) aufweisen, und wobei ein Maximalwert eines zwischen dem ersten Schaltungsanschluss (89) und dem zweiten Schaltungsanschluss (90) erzielten Spannungshubes größer als die vorgegebene maximale Sperrspannung ist, ein Source-Anschluss (88) eines n-ten MOS-Transistors (62) mit einem Drain-Anschluss (88) eines (n-1)-ten MOS-Transistors (64) verbunden ist, und die Schaltungsanordnung (60) die Potentiale an Steueranschlüssen des (n-1)-ten MOS-Transistors (64) und des n-ten MOS-Transistors (62) synchron zu einem Steuersignal verändert, **dadurch gekennzeichnet, dass** die Schaltungsanordnung neben dem n-ten MOS-Transistor (62) und dem (n-1)-ten MOS-Transistor (64) wenigstens einen weiteren MOS-Transistor (66) aufweist, dessen Source-Anschluss (68) an einem ersten Versorgungspotentialanschluss (70) liegt, dessen Drainanschluss (72) über einen ersten Widerstand (74) mit einem zweiten Versorgungspotential und über einen zweiten Widerstand (78) mit einem Drain-Anschluss (80) des n-ten MOS-Transistors (62) verbunden ist, und dass ein Steueranschluss (82) des n-ten MOS-Transistors (62) mit einem Mittelabgriff (84) eines Spannungsteilers (86) verbunden ist, der zwischen dem Drain-Anschluss (88) des (n-1)-ten MOS-Transistors (64) und dem ersten Versorgungspotential der Schaltungsanordnung (60) liegt.

2. Integrierte Schaltungsanordnung (98) mit einem ersten Schaltungsanschluss (12), einem zweiten Schaltungsanschluss (14) und MOS-Transistoren (120, 118, 116), wobei die MOS-Transistoren (120, 118, 116) jeweils einen Source-Anschluss und einen Drain-Anschluss und eine vorgegebene maximale Sperrspannung zwischen Source-Anschluss und Drain-Anschluss aufweisen, und wobei ein Maximalwert eines zwischen dem ersten Schaltungsanschluss (12) und dem zweiten Schaltungsanschluss (14) erzielten Spannungshubes größer als die vorgegebene maximale Sperrspannung ist, ein Source-Anschluss eines n-ten MOS-Transistors (120, 118) mit einem Drain-Anschluss eines (n-1)-ten MOS-Transistors (118, 116) verbunden ist, und die Schaltungsanordnung (98) die Potentiale an Steueranschlüssen des (n-1)-ten MOS-Transistors (118, 116) und des n-ten MOS-Transistors (120, 118) synchron zu einem Steuersignal verändert, **gekennzeichnet durch** folgende Merkmale: Die Schaltungsanordnung (98) weist einen Lastkreis und eine Steuerschaltung (30) auf; der Lastkreis weist eine Reihenschaltung einer ersten Anzahl r von MOS-Transistoren (120, 118, 116) zwischen dem ersten Schaltungsanschluss (12) und dem zweiten Schaltungsanschluss (14) auf; die Steuerschaltung (30) weist eine erste Reihenschaltung (100) der Anzahl r von ersten MOS-Transistoren (106, 104, 102) zwischen einem dritten Schaltungsanschluss (138) und einem vierten Schaltungsanschluss (168) sowie eine zweite Reihenschaltung (108) der Anzahl r von zweiten MOS-Transistoren (114, 112, 110) zwischen einem fünften Schaltungsanschluss (166) und einem sechsten Schaltungsanschluss (170) auf, welche ersten MOS-Transistoren (106, 104, 102) komplementär zu den zweiten MOS-Transistoren (114, 112, 110) und den MOS-Transistoren (120, 118, 116) des Lastkreises sind; die Steuerschaltung (30) weist ferner ein Widerstandsnetzwerk mit einer zweiten Anzahl s von Knotenpunkten (139, 179, 177, 175) auf, wobei die zweite Anzahl s um eines größer als die erste Anzahl r ist; der sechste Schaltungsanschluss (170) liegt auf einem Referenzpotential; der erste Schaltungsanschluss (12) ist mit dem dritten Schaltungsanschluss (138) verbunden; ein Steueranschluss (122) des letzten (110) der zweiten Transistoren (114, 112, 110) bildet einen Steuereingang der Schaltungsanordnung (98); ein Steueranschluss eines m-ten MOS-Transistors (120, 118, 116) im Lastkreis ist mit einem Source-Drain-Gebiet (182, 181, 180) eines m-ten der ersten MOS-Transistoren (106, 104, 102) verbunden; ein Steueranschluss (128) eines ersten MOS-Transistors (106) der ersten MOS-Transistoren (106, 104, 102) ist mit einem Mittelabgriff eines resistiven Spannungsteilers (150, 164) zwischen dem dritten (138) und dem fünften Schaltungsanschluss (166) verbunden; der vierte Schaltungsanschluss (168) ist über einen Widerstand (158) mit dem sechsten Schaltungsanschluss (170) verbunden; ein erster Knotenpunkt (139) des Widerstandsnetzwerkes ist mit dem dritten Schaltungsanschluss (138), ein s-ter Knotenpunkt (175) des Widerstandsnetzwerkes mit dem sechsten Schaltungsanschluss (170) verbunden; je ein n-ter Knotenpunkt (139, 179, 177) des Widerstandsnetzwerkes ist mit einem (n+1)-ten Knotenpunkt (179, 177, 175) des Widerstandsnetzwerkes über einen Widerstand (178, 176, 174) verbunden; ein Steueranschluss (126, 128) eines m-ten der ersten MOS-Transistoren (104, 106), wobei die Anzahl m größer als die Anzahl eins und kleiner oder gleich der ersten Anzahl r ist, ist mit dem Mittelabgriff eines resistiven Spannungsteilers zwischen einem dem Steueranschluss des m-ten der ersten Transistoren vorangehenden Source-Drain-Gebiet (182, 181) und dem m-ten Knotenpunkt (179, 177) des Widerstandsnetzwerkes verbunden; und ein Steueranschluss (132, 130) eines m-ten der zweiten MOS-Transistoren (114, 112), wobei die Anzahl m größer oder gleich der Anzahl eins und kleiner als die erste Anzahl r ist, ist mit dem Mittelabgriff eines resistiven Spannungsteilers zwischen einem dem Steueranschluss (132, 130) des m-ten der zweiten Transistoren (114, 112) nachfolgenden Source-Drain-Gebiet (142, 140) und dem (m+1)-ten Knotenpunkt (179, 177) des Widerstandsnetzwerkes verbunden.

3. Integrierte Schaltungsanordnung (98) mit einem ersten Schaltungsanschluss (12), einem zweiten Schaltungsanschluss (14) und MOS-Transistoren (120, 118, 116), wobei die MOS-Transistoren (120, 118, 116) jeweils einen Source-Anschluss und einen Drain-Anschluss und eine vorgegebene maximale Sperrspannung zwischen Source-Anschluss und Drain-Anschluss aufweisen, und wobei ein Maximalwert eines zwischen dem ersten Schaltungsanschluss (12) und dem zweiten Schaltungsanschluss (14) erzielten Spannungshubes größer als die vorgegebene maximale Sperrspannung ist, ein Source-Anschluss eines n-ten MOS-Transistors (120, 118) mit einem Drain-Anschluss eines (n-1)-ten MOS-Transistors (118, 116) verbunden ist, und die Schaltungsanordnung (98) die Potentiale an Steueranschlüssen des (n-1)-ten MOS-Transistors (118, 116) und des n-ten MOS-Transistors (120, 118) synchron zu einem Steuersignal verändert, **gekennzeichnet durch** folgende Merkmale: Die Schaltungsanordnung (98) weist einen Lastkreis und eine Steuerschaltung (30) auf; der Lastkreis weist eine Reihenschaltung einer ersten Anzahl r von MOS-Transistoren (120, 118, 116) zwischen einem ersten Schaltungsanschluss (12) und einem zweiten Schaltungsanschluss (14) auf; die Steuerschaltung (30) weist eine erste Reihenschaltung (100) der Anzahl r von ersten MOS-Transistoren (106, 104, 102) zwischen einem dritten Schaltungsanschluss (138) und einem vierten Schaltungsanschluss (168) sowie eine zweite Reihenschaltung (108) der Anzahl r von zweiten MOS-Transistoren (114, 112, 110) zwischen einem fünften Schaltungsanschluss (166) und einem sechsten Schaltungsanschluss (170) auf, welche ersten MOS-Transistoren (106, 104, 102) komplementär zu den zweiten MOS-Transistoren (114, 112, 110) und den MOS-Transistoren (120, 118, 116) des Lastkreises sind; der sechste Schaltungsanschluss (170) liegt auf einem Referenzpotential; der erste Schaltungsanschluss (12) ist mit dem dritten Schaltungsanschluss (138) verbunden; ein Steueranschluss (122) des letzten zweiten Transistors (110) der zweiten Transistoren (114, 112, 110) bildet einen Steuereingang der Schaltungsanordnung (98); ein Steueranschluss eines m-ten MOS-Transistors (120, 118, 116) im Lastkreis ist mit einem Source-Drain-Gebiet (182, 181, 180) eines m-ten der ersten MOS-Transistoren (106, 104, 102) verbunden; ein Steueranschluss (128) eines ersten MOS-Transistors (106) der ersten MOS-Transistoren (106, 104, 102) ist mit einem Mittelabgriff eines resistiven Spannungsteilers (150, 164) zwischen dem dritten (138) und dem fünften Schaltungsanschluss (166) verbunden; der vierte Schaltungsanschluss (168) ist über einen Widerstand (158) mit dem sechsten Schaltungsanschluss (170) verbunden; ein Steueranschluss (126, 124) eines m-ten der ersten MOS-Transistoren (104, 102), wobei die Anzahl m größer als die Anzahl eins und kleiner oder gleich der ersten Anzahl r ist, ist mit einem Mittelabgriff eines kapazitiven Spannungsteilers aus Kapazitäten (190, 186; 188, 184) zwischen einem dem Steueranschluss (126, 124) des m-ten der ersten Transistoren (104, 102) vorangehenden Source-Drain-Gebiet (182, 181) und einem Steueranschluss (132, 130) eines (m-1)-ten der zweiten Transistoren (114, 112) verbunden; und der Steueranschluss (132, 130) des m-ten der zweiten MOS-Transistoren (114, 112), wobei die Anzahl m größer oder gleich der Anzahl eins und kleiner als die erste Anzahl r ist, ist mit einem Mittelabgriff eines kapazitiven Spannungsteilers aus Kapazitäten (186, 194; 184, 192) zwischen einem dem Steueranschluss (132, 130) des m-ten der zweiten Transistoren (114, 112) nachfolgenden Source-Drain-Gebiet (142, 140) und dem Steueranschluss (126, 124) des (m+1)-ten der ersten Transistoren (104, 102) verbunden.

4. Schaltungsanordnung (98) nach Anspruch 3, **dadurch gekennzeichnet, dass** ein Teil (188, 190, 192, 194) der Kapazitäten (184, 186, 188, 190, 192, 194) durch parasitäre Kapazitäten der MOS-Transistoren (104, 106, 112, 114) realisiert ist.

5. Schaltungsanordnung (60; 98) nach einem der Ansprüche 1 bis 4, **dadurch gekennzeichnet, dass** pn-Übergänge verschiedener MOS-Transistoren in verschiedenen, durch Isolationsstrukturen (46) voneinander getrennten Bereichen (40, 42) eines Halbleitersubstrates auf verschiedenen Potentialen liegen.
